# EUROPÄISCHE PATENTSCHRIFT

(11) **EP 2 721 559 B1**
(45) Veröffentlichungstag und Bekanntmachung des Hinweises auf die Patenterteilung: **30.12.2015**
(21) Anmeldenummer: 12729867.7
(22) Anmeldetag: 14.06.2012
(51) Int. Cl.: G06K 19/077, B29C 45/14, B29C 45/37

(54) **VERFAHREN ZUR HERSTELLUNG EINES DATENTRÄGERS**
METHOD FOR PRODUCING A DATA CARRIER
PROCÉDÉ POUR PRODUIRE UN SUPPORT DE DONNÉES

(30) Priorität: 17.06.2011 DE 102011104510
(43) Veröffentlichungstag der Anmeldung: 23.04.2014
(73) Patentinhaber: Giesecke & Devrient GmbH, 81677 München (DE)
(72) Erfinder: BÜTTNER, Bernhard, 82110 Germering (DE); TARANTINO, Thomas, 83410 Laufen (DE); GRIESMEIER, Robert, 83052 Bruckmühl OT Heufeldmühle (DE)
(86) Internationale Anmeldenummer: PCT/EP2012/002531
(87) Internationale Veröffentlichungsnummer: WO 2012/171649

(56) Entgegenhaltungen:
- DE-A1-102004 028 218

## Beschreibung

Die Erfindung betrifft ein Verfahren zur Herstellung eines tragbaren Datenträgers, insbesondere einer Chipkarte sowie einen tragbaren Datenträger und die Verwendung des Datenträgers als Teilnehmeridentifikationsmodul, kurz (U)SIM. Besonders betrifft die Erfindung die Herstellung von Chipkarten mit kleineren Außenabmessungen, als die zum Zeitpunkt der Anmeldung normierten Standardabmessungen liegen.

Im ISO/IEC 7816-2 Standard sind die Abmessungen für den kleinsten Formfaktor, der sogenannte 3FF oder "Micro-SIM" oder "Mini-Plug-In" definiert. Dieser 3FF Standard hat die Außenmaße von ca. 12 mm x 15 mm. In der ISO/IEC 7816-2 Norm sind darüber hinaus auch die Mindestgröße, die Anzahl und die genaue Lage der Kontaktflächen des Kontaktfeldes von Chipkarten beschrieben.

Gemäß der DE 10 2004 028 218 A1 ist ein Herstellungsverfahren für Datenträger bekannt, bei dem ein Trägerband, auch als Filmträger bezeichnet, vorgesehen ist. Auf einer Oberseite des Trägerbandes wird ein Kontaktfeld mit einzelnen Kontaktflächen ausgebildet. Anschließend wird ein Halbleiterschaltkreis auf eine der Oberseite gegenüberliegenden Unterseite angeordnet und elektrisch mit den Kontaktflächen der Oberseite verbunden. Abschließend wird der Halbleiterschaltkreis auf der Unterseite mittels einer Vergussmasse ummantelt. Dies geschieht bevorzugt in einem Spritzgussprozess. Die Vergussmasse weist dabei bereits die Außenmaße, der in der Normungsspezifikation für die Außenmaße eines tragbaren Datenträgers entsprechend beschriebenen Außenmaße auf. Auf die gesamte Offenbarung der DE 10 2004 028 218 A1 wird hier ausdrücklich Bezug genommen. Der tragbare Datenträger steht dabei mit dem Endgerät über die physikalische Schnittstelle eines Kontaktfelds zum Austausch von Daten in Kommunikationsverbindung. Es ist allgemeiner Trend, dass diese Endgeräte stetig kleiner, kompakter und mit mehr Funktionalität ausgestattet werden. Durch die zunehmende Miniaturisierung von mobilen Kommunikationsendgeräten und der stets steigenden Funktionsfähigkeit dieser Geräte, ist es wünschenswert, auch die im Endgerät betriebenen tragbaren Datenträger zu verkleinern. Mit weiterer Miniaturisierung der Endgeräte wird diese benötigte Fläche jedoch nicht geringer, sodass die Gesamtgröße der Endgeräte durch die standardisierten Größen der Datenträger stark beeinflusst wird.

In Anbetracht einer zunehmenden Miniaturisierung von mobilen Kommunikationsendgeräten bzw. einer steigenden Funktionalität der Kommunikationsendgeräte, ist ein stetiges Bedürfnis an der weiteren Verkleinerung der als "Mini-Plug-In" bezeichneten Standard für SIM-Chipkarten abzusehen und wünschenswert.

Ein Bedürfnis ist weiterhin, dass die Datenträger weiterhin in älteren Kommunikationsgeräten bzw. in Endgeräten, die einen anderen Formfaktor für SIM-Karten benötigen, betrieben werden können, somit ist es wünschenswert das gemäß ISO/IEC 7816-2 standardisierte Kontaktfeld auch für zukünftige Formstandards beizuhalten. Die kleinste denkbare Fläche, die ein Datenträger zukünftig aufweisen sollte, ist somit die Fläche des Kontaktfelds.

Mit einem Herstellungsverfahren gemäß der DE 10 2004 028 218 A1 ist es möglich Kartenkörper zu formen, die die Fläche des Kontaktfeldes nicht überschreiten oder bei denen der Rand des Kontaktfeldes eine geringe Distanz zu dem Randbereich des Datenträgerkörpers aufweist als die bisherig definierten Standards für Datenträger gemäß ISO/ IEC 7816. Beim Umgießen eines Halbleiterschaltkreises mittels Vergussmasse muss darauf geachtet werden, dass der fertig gestellte Datenträger schnell und einfach aus der Vergussmasseform entnommen werden kann. Daher werden Flankenwinkel zwischen Seitenfläche und Oberseite des Datenträgers größer Null Grad, insbesondere 10 Grad verwendet. Durch das leichte Abschrägen der Flanken ist der Datenträger leichter und schneller aus der Vergussmassenform entnehmbar.

Im heutigen ISO/IEC 7816 Standard sind insbesondere der Eckenradien des Datenträgers und der Flankenwinkel zwischen Seitenfläche und Oberseite des Datenträgers streng vorgegeben, sodass eine einheitliche Bauform der Standards gegeben ist. Es ist also davon auszugehen, dass eine Standardisierung eines Formfaktors, kleiner dem 3FF Standard, ebenfalls diesen Beschränkungen unterliegt. Aus der DE 10 2004 028 218 A1 kann nicht entnommen werden, wie diese Vorgaben für Eckenradien und Flankenwinkel tatsächlich eingehalten werden.

Ein weiters Problem betrifft die Handhabung des Datenträgers selbst. Wird der Datenträger nun bestimmungsgemäß zum Datenaustausch in ein Endgerät eingebracht, wird er zumeist mechanisch lösbar im Endgerät fixiert, beispielsweise durch Einklemmen, Einrasten oder Einschieben bzw. allgemein durch Halten des Datenträgers. Die Handhabung des Datenträgers im 3FF Format ist insbesondere beim Wechseln der Datenträger im Endgerät aufgrund der geringen Abmessungen schwierig. Wird der Datenträger weiter miniaturisiert, wird diese Handhabung weiter erschwert.

Der Erfindung liegt daher die Aufgabe zugrunde, einen Datenträger herzustellen, der einfacher Handhabbar ist und trotzdem den Vorschriften eines zukünftigen Standards entspricht.

Die Aufgabe der Erfindung wird durch die in den nebengeordneten unabhängigen Patentansprüchen beschriebenen Maßnahmen gelöst. Vorteilhafte Ausgestaltungen sind in den jeweils abhängigen Ansprüchen beschrieben.

Insbesondere wird die Aufgabe durch ein Verfahren zur Herstellung eines tragbaren Datenträgers, insbesondere einer Chipkarte, gelöst. Das Verfahren umfasst die Schritte: Bereitstellen eines Trägerbands mit einer Oberseite und einer der Oberseite gegenüberliegenden Unterseite, wobei auf der Oberseite ein Kontaktfeld mit mindestens einer Kontaktfläche ausgebildet ist; Anordnen eines Halbleiterschaltkreises auf der Unterseite des Trägerbands, wobei der Halbleiterschaltkreis mit der entsprechenden Kontaktfläche elektrisch leitend verbunden wird; und Ausführen eines Spritzgussprozesses in der Art, dass auf der Unterseite um den Halbleiterschaltkreis herum eine Vergussmasse ausgebildet wird, wobei diese Vergussmasse die Außenmaße gemäß einer Standardspezifikation eines tragbaren Datenträgers aufweist. Das Verfahren zeichnet sich dadurch aus, dass nach dem Einspritzen der Vergussmasse eine Vertiefung auf einer der Unterseite parallelen Seite des Datenträgerkörpers im fertig gestellten Datenträger bleibt.

Mit Vertiefung ist jegliche bereichsweise Absenkung des Datenträgers auf der der Unterseite parallelen Seite des Datenträgerkörpers gemeint. Dies kann eine quer- oder längs geführte Rille, eine geometrische Figur, beispielsweise ein Kreis oder eine Ellipse oder auch ein anders geartetes Konstrukt sein.

Durch dieses Verfahren wird in vorteilhafter Weise eine Vertiefung an der Unterseite des Datenträgers angeordnet. Durch diese Vertiefung wird es einem Benutzer vereinfacht ermöglicht, mit dem Datenträger umzugehen. Insbesondere beim Einbringen oder Herausnehmen des Datenträgers aus einer Halterung in einem Endgerät, wo der Datenträger bestimmungsgemäß eingebracht wird, um in Datenaustausch mit dem Endgerät zu treten, wird es durch die Vertiefung ermöglicht, den Datenträger zu wechseln. Die Vertiefung macht es beispielsweise einem Benutzer möglich, mittels seines Fingernagels oder eines entsprechenden Gegenstandes, den Datenträger aus der Halterung zu nehmen.

Besonders vorteilhaft ist es, wenn der Einspritzkanal zum Einspritzen der Vergussmasse auf der der Unterseite des Trägerbands parallelen Seite der Vergussmasseform angeordnet ist, wodurch die Vertiefung erhalten wird. Das Einspritzen auf diese Art wird in der Fachwelt auch als Top-Gating bezeichnet.

Insbesondere ist die Vertiefung mittig auf dem Datenträger angeordnet und in einem inneren Bereich der Vertiefung sind Unebenheiten enthalten. Der Datenträgerkörper weist trotz der Unebenheiten keine Höhe auf, die über die gemäß Standardspezifikation beschriebene maximale Höhe des Datenträgerkörpers hinaus geht. Durch diese Unebenheiten wird es dem Benutzer verbessert ermöglicht, den Datenträger zu handhaben, insbesondere beim Wechseln des Datenträgers in einem Endgerät.

Besonders vorteilhaft ist es, wenn die Vergussmasse eine erste Vergussmasse ist und der Halbleiterschaltkreis vor dem Spritzgussprozess bereits mit einer zweiten Vergussmasse ummantelt ist. Die zweite Vergussmasse ist dann aus einem der ersten Vergussmasse unterschiedliches Material. Die zweite Vergussmasse kann damit einen größeren Flankenwinkel und einen größeren Eckenradius aufweisen, sodass der Herstellungsprozess beim Chiphersteller unverändert bleiben kann. Um aber die Vorschriften einer Formstandardisierung einzuhalten, wird anschließend mit einem anderen Material der Datenträger erneut umspritzt. Dieses Material der ersten Vergussmasse weist verbesserte Fließeigenschaften auf, sodass durch eine andere Viskosität ein geringerer Eckenradius erhalten wird. Das Material kann weiterhin einen schwächeren Aushärtegrad und eine geringere Stabilität aufweisen, sodass steilere Flankenwinkel erhalten werden. Das Material der ersten Vergussmasse ist dadurch besser formbar.

Zur Verbesserung des Vereinzelns des Datenträgers ist das Trägerband derart vorgestanzt ist, dass beim Vereinzeln der Datenträger weniger Trägerbandmaterial durchtrennt wird. Dadurch wird weniger mechanischer Stress beim Vereinzeln auf den Datenträger ausgeübt, wodurch eine Delamination zwischen Trägerband und Vergussmasse verhindert wird.

Der Datenträger wird vor einem Vereinzelungsschritt in einer Personalisierungseinheit elektrisch personalisiert wird, wodurch eine Individualisierung des Datenträgers erfolgt. Insbesondere wird der Datenträger vor einem Vereinzelungsschritt optisch personalisiert.

Der Datenträger wird vorteilhafter Weise dadurch vereinzelt, indem der mit der Vergussmasse verbundene Teil des Trägerbandes von dem restlichen Trägerband getrennt wird.

Im Erfindungsgrundgedanken ist weiterhin ein tragbarer Datenträger zum kontaktbehafteten Datenaustausch mit einem Endgerät. Der Datenträger weist ein Trägerband mit einer Oberseite und einer der Oberseite gegenüberliegenden Unterseite, wobei auf der Oberseite ein Kontaktfeld mit mindestens einer Kontaktfläche ausgebildet ist; einen Halbleiterschaltkreis auf der Unterseite, wobei der Halbleiterschaltkreis elektrisch leitend mit der mindestens einen Kontaktfläche ist; und einen Datenträgerkörper aus einem Vergussmassematerial, wobei die Vergussmasse den Halbleiterschaltkreis umgibt, auf. Die Vergussmasse weist die Außenmaße gemäß einer Standardspezifikation eines tragbaren Datenträgers auf. Der fertig gestellte Datenträgerkörper weist auf einer der Unterseite parallelen Seite eine Vertiefung auf.

Der Datenträger wird bevorzugt als Teilnehmeridentifikationsmodul für den bestimmungsgemäßen Einsatz in einem Endgerät verwendet. Dazu weist das Teilnehmeridentifikationsmodul die Funktionalitäten auf, wie sie in der technischen Spezifikationen ETSI TS 102 221 und ETSI TS 102 671, als sogenannten Universal Integrated Circuit Cards, kurz UICC, beschrieben sind. Die Außenkontur des Teilnehmeridentifikationsmoduls ist mit Ausnahme der Oberseite metallfrei ist.

Bei dem erfindungsgemäßen tragbaren Datenträger handelt es sich vorzugsweise um Datenträger mit entsprechenden Sicherheitsfunktionalitäten, wie z.B. Smart Cards, Chipkarten, Token und/ oder Teilnehmeridentifikationskarten in einem mobilen Funknetz, um durch eine entsprechende Authentisierung einen Zugang zu gesicherten Bereichen oder Dienstleistungen zu erhalten, z. B. die über ein Mobilfunknetzes bereitgestellten Applikationen eines Mobilfunkanbieters. Es ist auch möglich dass das Teilnehmeridentifikationsmodul als M2M Modul als fester Bestandteil im Datenträger eingebracht wird.

Nachfolgend wird anhand von Figuren die Erfindung bzw. weitere Ausführungsformen und Vorteile der Erfindung näher erläutert, wobei die Figuren lediglich Ausführungsbeispiele der Erfindung beschreiben. Gleiche Bestandteile in den Figuren werden mit gleichen Bezugszeichen versehen. Die Figuren sind nicht als maßstabsgetreu anzusehen, es können einzelne Elemente der Figuren übertrieben groß bzw. übertrieben vereinfacht dargestellt sein.

Es zeigen:
Figur 1 Ein Trägerband zur Herstellung eines tragbaren Datenträgers mit ausgebildeten Kontaktflächen gemäß dem Stand der Technik
Figur 2 Ein Querschnitt durch einen Datenträger gemäß dem Stand der Technik vor dem Umspritzen entlang der Schnittlinie A-A' der Figur 1
Figur 3 Ein Querschnitt durch einen Datenträger gemäß dem Stand der Technik nach dem Umspritzen entlang der Schnittlinie A-A' der Figur 1
Figur 4 Ein Querschnitt durch einen erfindungsgemäßen Datenträger vor dem Umspritzen entlang der Schnittlinie A-A'
Figur 5 Ein Querschnitt durch einen erfindungsgemäßen Datenträger nach dem Umspritzen
Figur 6 Ein Querschnitt durch einen erfindungsgemäßen Datenträger nach dem Umspritzen in alternativer Weise hergestellt
Figur 7 Ein Querschnitt durch einen erfindungsgemäßen Datenträger nach dem Umspritzen beim Schritt des Vereinzelns

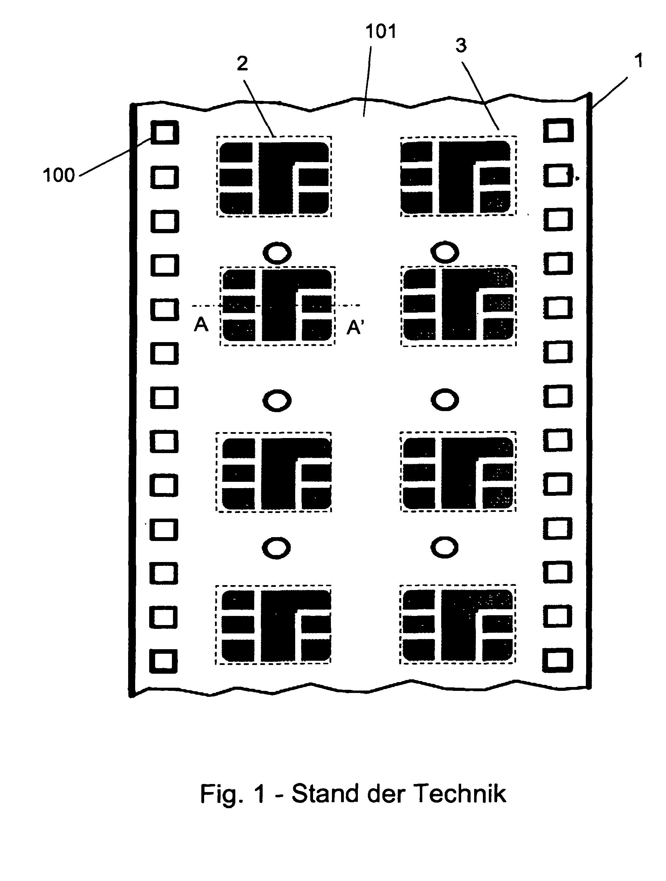

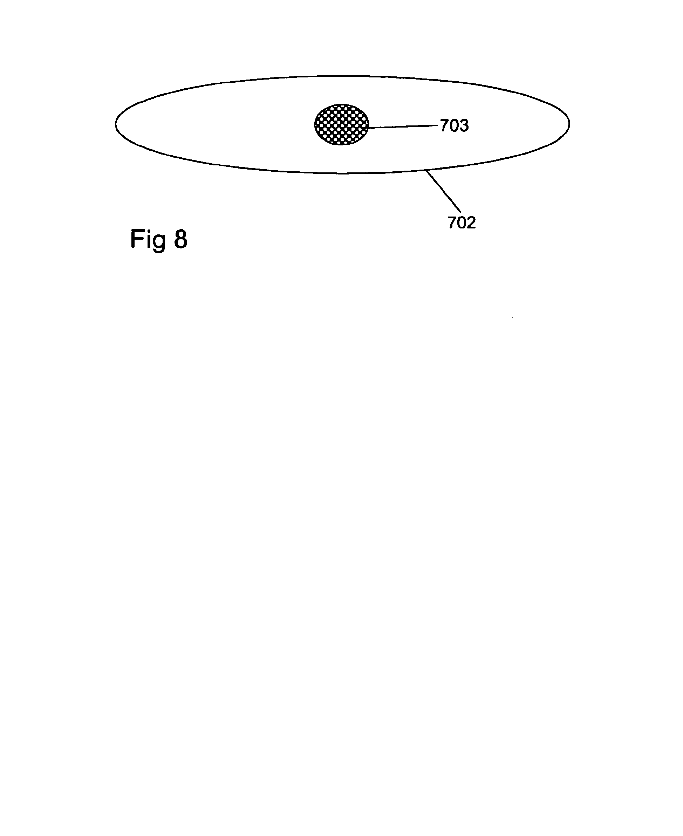

Figur 8 Ein Ausführungsbeispiel einer erfindungsgemäßen Vertiefung In Figur 1 ist ein Ausschnitt eines Trägerbands 1 in einer Draufsicht auf eine Oberseite 101 aus dem Stand der Technik dargestellt. Das Band 1 stellt das Ausgangsmaterial für das erfindungsgemäße Herstellungsverfahren dar. Das Trägerband 1 ist beispielsweise ein Filmträger aus einem rollbaren Trägermaterial auf Kunststoffbasis und/ oder FR4 Basis, also ein glasfaserverstärktes Epoxid-Laminat, der an den Seiten Perforationen 100 zur Unterstützung des Transports bei der Verarbeitung aufweist. Ebenfalls sind Kontaktfelder 2 auf der Oberseite 101 dargestellt. Auf der gegenüberliegenden Unterseite 102 des Trägerbands 1 ist der Datenträgerkörper 3 mit dem integrierten Halbleiterschaltkreis 4 angeordnet, was hier durch eine Strichlinie angedeutet ist.

Zur Ausbildung der Kontaktfelder 2 auf der Oberseite 101 wird ein elektrochemisches Verfahren, die Galvanotechnik angewendet. Die Kontaktfelder 2 entsprechen dabei einem Normlayout für Chipkarten gemäß ISO/IEC 7816.

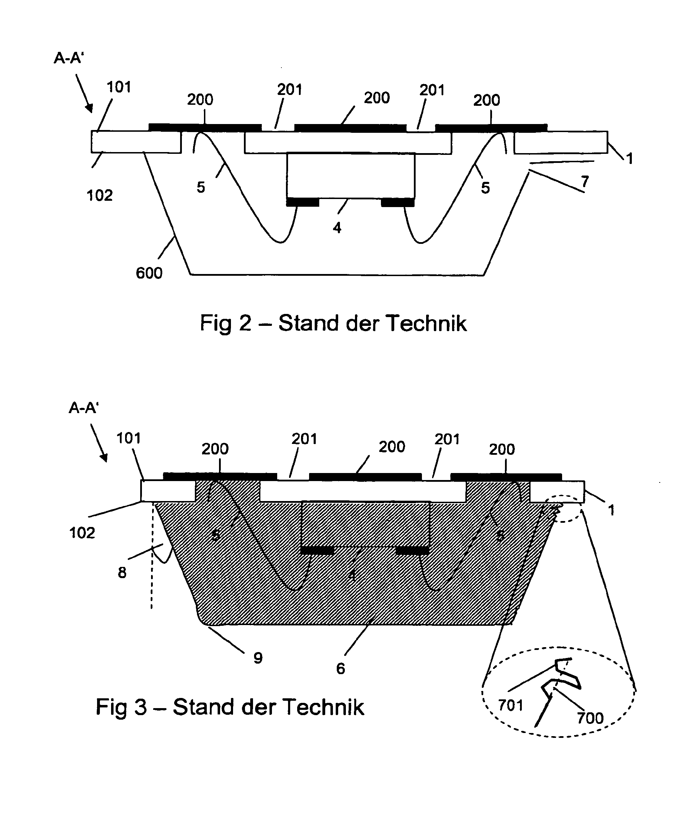

In Figur 2 ist ein Querschnitt durch einen Datenträger gemäß dem Stand der Technik vor dem Umspritzen entlang der Schnittlinie A-A' der Figur 1 dargestellt. Der Datenträger weist ein Trägerband 1 auf, auf dessen Oberseite 101 Kontaktflächen 200 und entsprechende Trennlinien 201 zwischen den Kontaktflächen ausgebildet sind, wodurch die Kontaktflächen 200 untereinander elektrisch isoliert bzw. getrennt sind. Auf der Unterseite 102 des Trägerbands ist ein Halbleiterschaltkreis 4 angeordnet, der über elektrisch leitende Verbindungen 5 mit entsprechenden Kontaktflächen 200 verbunden ist. Die Ausgestaltung der Verbindungen 5 erfolgt entweder in Wire-Bond Technologie, so wie hier gezeigt oder in einer nicht dargestellten Flipchip Technologie.

Herkömmlich wird um den Halbleiterschaltkreis 4 eine Vergussmasseform 600 angeordnet, die dem Datenträger seine endgültige Form geben soll. Diese Form weist einen Einspritzkanal 7 auf, der sich an einer zum Trägerband orthogonalen Seite befindet. Bevorzugt ist der Einspritzkanal in der Nähe des Trägerbands 1 angeordnet. Durch den Einspritzkanal 7 wird die Vergussmasse 6, die den Datenträgerkörper 4 bilden soll, eingespritzt. Sie umgibt den gesamten Halbleiterchip 4 und die elektrischen Verbindungen 5.

Bei dem Halbleiterschaltkreis 4 handelt es sich um einen für Chipkarten typischen "Chip", d.h. um einen durch Prozessierung eines Wafers erzeugten integrierten Schaltkreis, der in der Regel alle Merkmale eines ressourcenbeschränkten Computers aufweist. Herstellung des Chips ebenso wie die Vorbereitung des Trägerbands 1 durch Aufbringen von Kontaktlayout, Kontaktierungsflächen und Chip sind in der Fachwelt bekannt und unter anderem in dem Buch "Vom Plastik zur Chipkarte" oder auch in dem Buch "Handbuch der Chipkarten" von W. Rankl, W. Effing, Hanser Verlag, 4. Auflage, ausführlich beschrieben. Für Details zur Durchführung der Bearbeitungsschritte wie zu Aufbau und Funktion des integrierten Schaltkreises wird deshalb auf die einschlägige Literatur, insbesondere die genannten Bücher, verwiesen.

Figur 3 zeigt den Datenträger der Figur 2 an der Schnittlinie A-A' der Figur 1 nach dem Spritzgießprozess. Aufgrund der Beschaffenheit der Vergussmasse 6 sind die Eckenradien 9 sehr groß. Auch die Flankenwinkel 8 sind größer null Grad. Weiterhin befindet sich im Bereich des Einspritzkanals 7 ein Grat, der aufgrund des Einspritzprozess entstanden ist. In einer Vergrößerung der Grat-Stelle ist erkennbar, dass die tatsächliche Form 701 von der Idealform 700 der Vergussmasseform 600 abweicht. Es kann bei einem derartigen seitlichen Einspritzen, auch als Degating bezeichnet, nicht ausgeschlossen werden, dass der resultierende Grat über die Vergussmasseformgrenzen hinaus ausgebildet wird, sodass die Maximalgröße des Datenträgers überschritten wird.

Da entsprechende zukünftige Normen vorschreiben könnten, dass sowohl Flankenwinkel und Eckenradius verringert werden müssen und der Grat entfernt werden muss, sind weitere Herstellungsschritte notwendig, um den Datenträger normgerecht herzustellen.

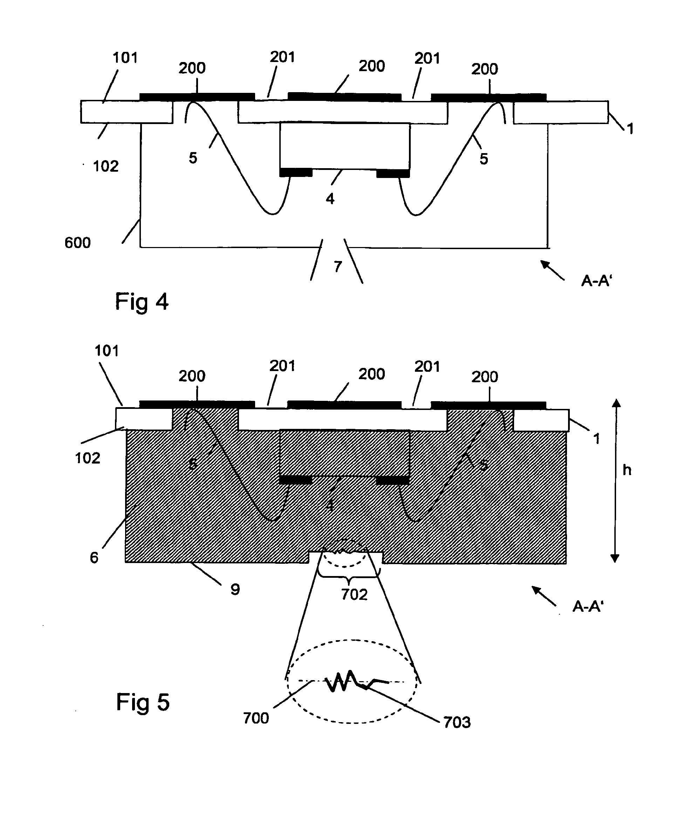

In Figuren 4 und 5 ist ein erstes erfindungsgemäßes Verfahren zur Herstellung eines Datenträgers dargestellt. Auf der Unterseite 102 des Trägerbandes 1 wird eine Vergussmasseform 600 angeordnet, die einen Datenträgerkörper 3 in den Außenmaßen der Standardspezifikation formen wird. Es wird dabei darauf geachtet, dass der Flankenwinkel 8 null grad ist und auch die Eckenradien 9 wesentlich verkleinert, insbesondere viel kleiner als im herkömmlichen Herstellungsverfahren sind. Wesentlicher Unterschied zu dem Herstellungsverfahren gemäß Figuren 2 und 3 ist die Anordnung des Einspritzkanals 7 für die Vergussmasse 6. Dieses Verfahren wird als Topgating bezeichnet und erzielt in der hier artfremden Anwendung überraschend den Effekt, dass eine Vertiefung 702 entsteht, die für die Handhabung des Datenträgers wesentliche Vorteile bringt.

In Figur 5 ist nun der in Figur 4 beschriebene Datenträger nach dem Einspritzprozess dargestellt. Durch das Topgating, also das Anordnen des Einspritzkanals 7 auf eine der Unterseite 102 des Trägerbands 1 parallelen Seite des Datenträgerkörpers 3, entsteht die Vertiefung 702. In einer vergrößerten Darstellung ist ersichtlich, dass Unebenheiten 703 innerhalb der Vertiefung 700 enthalten sind. Durch diese Vertiefung 702 und die darin enthaltenen Unebenheiten 703 wird es einem Benutzer stark vereinfacht den Datenträger aus dem Endgerät herauszunehmen beziehungsweise in das Endgerät einzubringen.

Der hier beschriebene Datenträger hat ein ausgebildetes Kontaktfeld 2 mit sechs beziehungsweise sieben Kontaktflächen 200. Der Datenträgerkörper 3 weist eine wesentlich kleinere Oberfläche als die gemäß 3FF Standard bislang spezifizierte Ausführungsform eines Datenträgers auf. Die Kontaktflächen 200 sind untereinander elektrisch getrennt, was durch die Trennlinie 201 angedeutet ist. Ein derart miniaturisierter Datenträger gemäß Figur 4 und 5 ist beispielsweise in der DE 10 2011100 070 vom Anmelder am 29. April 2011 beim DPMA eingereicht oder in der DE 10 2011 112 031 A1 beschrieben. Darin ist auch die Ausgestaltung des Kontaktfelds 2 mit einer siebten Kontaktflächen C9 beschrieben, die eine zusätzliche Trennlinie 201 benötigt. Die Kontaktfläche C9 ist insbesondere nützlich, wenn man mit einer Vielzahl unterschiedlicher Kommunikationsprotokolle, beispielsweise USB, ISO, SWP Daten mit einem Endgerät austauschen möchte. Die Belegung der Kontakte und die Beschaltung kann den erwähnten Anmeldungen ebenfalls entnommen werden.

Weiterhin ist die Form der in Figur 4 und 5 hergestellten Datenträger mit zukünftigen Standards konform, da der Flankenwinkel 8 und der Eckenradius 9 an bereits heutigen Standards angepasst sind. Insbesondere ist die Höhe h des Datenträgerkörpers geringer oder gleich der gemäß Standard vereinbarten Höhe.

Das für den Spritzgießvorgang zu verwendende Werkzeug besteht aus zwei Gießformhälften, wobei die untere Gießformhälfte an der Oberseite des Trägerbands 1 anliegt und als Unterlage dient. Die obere Gießformhälfte liegt dicht auf der Unterseite des Trägerbands 1 auf und umschließt unter Belassen einer Kavität den Halbleiterschaltkreis 6 mit Kontaktierungsflächen C1-C9 und ggf. vorhandenen weiteren Kontaktierungsstrukturen, etwa in Form von Bonddrähten. Die von der oberen Gießformhälfte umschlossene Kavität besitzt die für den fertigen tragbaren Datenträger angestrebte äußere Endform, ggf. korrigiert um einen Höhenabzug für die Dicke d des Trägerbands 1. Bei der Endform des Datenträgerkörpers 3 kann es sich insbesondere um eine Geometrie mit den Standardabmessungen handeln, wie sie ggf. zukünftig von ETSI als neues Format diskutiert wird.

Der so bereits weitgehend fertig gestellte tragbare Datenträger wird anschließend individualisiert. Hierzu wird der Chipkartenkörper 3 mit darin eingebettetem Halbleiterschaltkreis 4 an eine Test- und Personalisierungseinrichtung gebracht. Diese verfügt insbesondere über eine Lese/ Schreibeinrichtung mit Kontaktstiften, welche auf die Kontaktflächen 200 stoßen, um eine Datenverbindung zu dem Halbleiterschaltkreis 4 herzustellen. Über diese Datenverbindung wird der Halbleiterschaltkreis 4 sodann in üblicher Weise getestet und anschließend mit individualisierenden Daten versehen, indem z.B. eine Seriennummer eingeschrieben wird.

Der getestete und individualisierte tragbare Datenträger wird nachfolgend einer Beschriftungsstation zugeführt, wo er z.B. mittels eines Lasers oder durch Bedrucken mit einem Inkjet-Drucker beschriftet oder mit grafischen Elementen versehen wird. Die Schritte der datenmäßigen Individualisierung und der nachfolgenden Beschriftung erfolgen zweckmäßig in der Rolle, d.h. während die Vergussmasse 6 noch mit dem Trägerband 1 verbunden ist. Die Perforationen 100 ermöglichen dabei eine einfache Bewegung des Trägerbands 1.

Der individualisierte Datenträger wird sodann vereinzelt. Mittels eines geeigneten Werkzeuges, z.B. einem Stanzwerkzeug, werden dabei die außerhalb der Vergussmasse 6 liegenden Teile des Trägerbands 1 entfernt. Der mit der Vergussmasse 6 verbundene Teil des Trägerbands 1verbleibt auf dem Vergussmasse 6 und wird zur Deckschicht des fertigen tragbaren Datenträgers. Alternativ zum Stanzen kann das Entfernen des Trägerbands 1 auch durch Schneiden, durch Einsatz eines Lasers oder durch ein chemisches Vereinzeln erfolgen. Der Vereinzelungsschritt kann auch zu einem früheren Zeitpunkt erfolgen, d.h. vor dem Beschriften oder vor dem Individualisieren in der Personalisierungseinrichtung. Die Durchführung der weiteren Bearbeitungsschritte kann dann z.B. im "Tray", d.h. in einer Art Tablett mit Vertiefungen, worin einzeln die Datenträger liegen, durchgeführt werden.

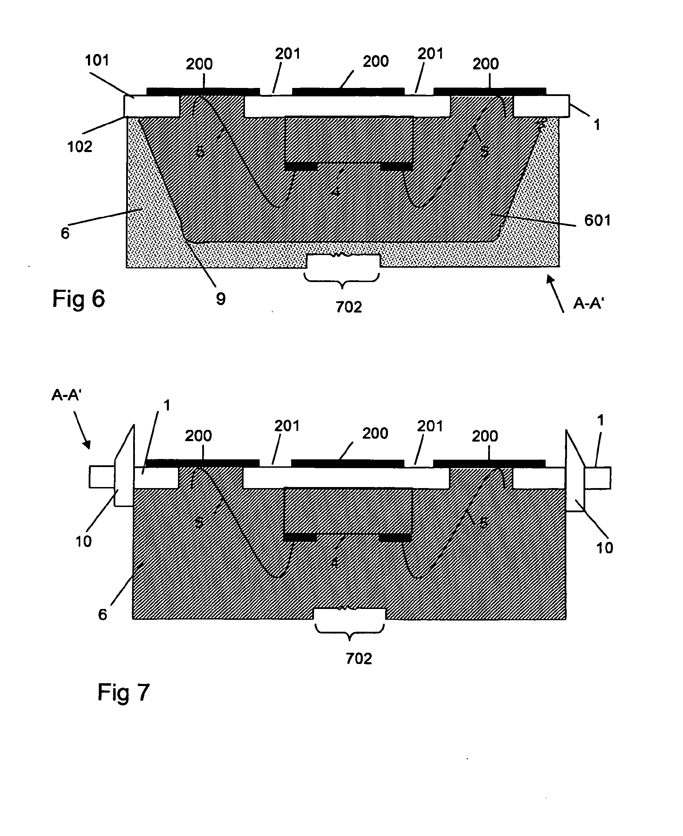

In Figur 6 ist ein zu den Figuren 4 und 5 alternatives Herstellungsverfahren gezeigt. Hier wird der Halbleiterchip 4 zunächst mit einer zweiten Vergussmasse 601 ummantelt. Zu beachten ist, dass die Abmessungen der zweiten Vergussmasse geringer sind als die gemäß Standard geforderten Außenmaße für einen standardisierten Datenträger. Um die zweite Vergussmasse 601 wird nun die erste Vergussmasse gemäß dem in Figur 4 und 5 beschriebenen Verfahren angeordnet. Aus der Figur 6 ist gut erkennbar, dass die erste Vergussmasse 6 einen viel geringeren Flankenwinkel 8, insbesondere geringer 5 Grad und einen geringeren Eckenradius 9 aufweist. Auch der durch das Degating entstandene Grat wird mit dem Topgating Verfahren ummantelt. Die gemäß Figur 6 dargestellte Vertiefung 702 dient der verbesserten Handhabung für einen Benutzer des Datenträgers. Vorteilhaft ist hierbei, dass das äußere Vergussmaterial andere Materialeigenschaften bezüglich Stabilität, Viskosität und Aushärtgrad im Vergleich zum inneren Vergussmaterial aufweisen kann, wodurch das zweite Material insbesondere preislich günstiger sein kann.

In Figur 7 ist wiederum ein alternatives Herstellungsverfahren dargestellt. Anstelle der zweiten Ummantelung des Halbleiterschaltkreises 4 wird der Datenträger mit im Vergleich zur Standardspezifikation größeren Außenabmessung bereitgestellt. Zur Verbesserung der Flankenwinkel 8, der Eckenradien 9 und zum Zweck des Vereinzelns wird der Datenträger nicht nur am Trägerband 1 vereinzelt, sondern beim Vereinzeln auch die Vergussmasse beschnitten. Dazu dient ein Schneidwerkzeug 10 oder ein Stanzwerkzeug. Alternativ kann die endgültige Form auch durch Lasern oder mittels eines chemischen Prozesses erzeugt werden.

In Figur 8 ist eine erfindungsgemäße Vertiefung 702 dargestellt. Diese Vertiefung 702 wird durch das Einspritzwerkzug erzeugt. In dieser Ausgestaltung ist die Form der Vertiefung 702 elliptisch, in Anlehnung an die Form des Finger bzw. des Fingernagels eines Benutzers. Im Inneren der Vertiefung 702 ist eine Unebenheit 703 ausgebildet, durch die die Handhabung des Datenträgers weiter verbessert wird.

### Bezugszeichenliste

- 1: Trägerband

- 100: Perforation
- 101: Oberseite
- 102: Unterseite

- 2: Kontaktfeld

- 200: Kontaktfläche
- 201: Trennlinie

- 3: Chipkartenkörper

- h: Höhe des Datenträgerkörpers

- 4: Halbleiterschaltkreis
- 5: Elektrische Kontaktierung zwischen Halbleiterschaltkreis und Kontaktflächen
- 6: Erste Vergussmasse

- 600: Vergussmasseform
- 601: zweite Vergussmasse

- 7: Einspritzkanal

- 700: Idealform
- 701: Tatsächliche Form
- 702: Vertiefung
- 703: Unebenheit

- 8: Flankenwinkel
- 9: Eckradius
- 10: Stanzwerkzeug
- A-A': Schnittlinie

## Patentansprüche

1. Verfahren zur Herstellung eines tragbaren Datenträgers, insbesondere einer Chipkarte, mit den Verfahrensschritten:
- Bereitstellen eines Trägerbands (1) mit einer Oberseite (101) und einer der Oberseite (101) gegenüberliegenden Unterseite (102), wobei auf der Oberseite (101) ein Kontaktfeld (2) mit mindestens einer Kontaktfläche (200) ausgebildet ist;
- Anordnen eines Halbleiterschaltkreises (4) auf der Unterseite (102) des Trägerbands (1), wobei der Halbleiterschaltkreis (4) mit der entsprechenden Kontaktfläche (200) elektrisch leitend verbunden wird; und
- Ausführen eines Spritzgussprozesses in der Art, dass auf der Unterseite (102) um den Halbleiterschaltkreis (4) herum eine Vergussmasse (6) ausgebildet wird, wobei diese Vergussmasse (6) die Außenmaße gemäß einer Standardspezifikation eines tragbaren Datenträgers aufweist **dadurch gekennzeichnet, dass**:
- ein Einspritzkanal (7) zum Einspritzen der Vergussmasse (6) auf einer der Unterseite (102) des Trägerbands (1) parallelen Seite eines Datenträgerkörpers (3) angeordnet wird, so dass am Ort des Einspritzkanals (7) eine Vertiefung (702) entsteht,
wobei der Datenträger ein Teilnehmeridentifikationsmodul für den bestimmungsgemäßen Einsatz in einem Endgerät ist und die Vertiefung (702) vorgesehen ist, einem Benutzer des Teilnehmeridentifikationsmoduls die Handhabung mit dem Teilnehmeridentifikationsmodul beim Einbringen in das Endgerät und/ oder beim Herausnehmen aus dem Endgerät zu vereinfachen.

2. Verfahren gemäß einem der vorhergehenden Ansprüche, wobei der Einspritzkanal (7) zum Einspritzen der Vergussmasse (6) auf der der Unterseite (102) parallelen Seite der Vergussmasseform (600) angeordnet ist, wodurch die Vertiefung (702) erhalten wird.

3. Verfahren gemäß einem der vorhergehenden Ansprüche, wobei die Vertiefung (702) mittig auf dem Datenträger angeordnet ist und in einem inneren Bereich der Vertiefung Unebenheiten (703) enthalten sind.

4. Verfahren gemäß einem der vorhergehenden Ansprüche, wobei die Vergussmasse (6) eine erste Vergussmasse (6) ist und der Halbleiterschaltkreis (4) vor dem Spritzgussprozess bereits mit einer zweiten Vergussmasse (601) ummantelt wurde.

5. Verfahren gemäß einem der vorhergehenden Ansprüche, wobei das Trägerband (1) derart vorgestanzt ist, dass beim Vereinzeln der Datenträger weniger Trägerbandmaterial durchtrennt wird.

6. Verfahren nach einem der vorhergehenden Ansprüche, wobei der Datenträger vor einem Vereinzelungsschritt in einer Personalisierungseinheit elektrisch personalisiert wird, wodurch eine Individualisierung des Datenträgers erfolgt.

7. Verfahren nach einem der vorhergehenden Ansprüche, wobei der Datenträger vor einem Vereinzelungsschritt optisch personalisiert wird.

8. Verfahren nach einem der vorhergehenden Ansprüche, wobei der Datenträger vereinzelt wird, indem der mit der Vergussmasse verbundene Teil des Trägerbandes (1) von dem restlichen Trägerband getrennt wird.

9. Tragbarer Datenträger, insbesondere eine Chipkarte, zum kontaktbehafteten Datenaustausch mit einem Endgerät, aufweisend:
- ein Trägerband (1) mit einer Oberseite (101) und einer der Oberseite (102) gegenüberliegenden Unterseite (102), wobei auf der Oberseite (101) ein Kontaktfeld (2) mit mindestens einer Kontaktfläche (200) ausgebildet ist;
- ein Halbleiterschaltkreis (4) auf der Unterseite(102), wobei der Halbleiterschaltkreis (4) elektrisch leitend mit der mindestens einen Kontaktfläche (200) ist;
- einen Datenträgerkörper (3) aus einem Vergussmassematerial, wobei die Vergussmasse (6) den Halbleiterschaltkreis (4) umgibt und die Vergussmasse (6) die Außenmaße gemäß einer Standardspezifikation eines tragbaren Datenträgers aufweist; **dadurch gekennzeichnet, dass**:
- der fertig gestellte Datenträgerkörper (3) auf einer der Unterseite (102) des Trägerbands (1) parallelen Seite des Datenträgerkörpers (3) eine Vertiefung (702) aufweist.

10. Tragbarer Datenträger gemäß Anspruch 9, wobei die Vertiefung (702) in einem inneren Bereich Unebenheiten (703) aufweist, wobei der Datenträgerkörper (3) trotz der Unebenheiten (703) nicht über die gemäß Standardspezifikation beschriebene maximale Höhe (h) des Datenträgerkörpers (3) hinausgeht.

11. Tragbarer Datenträger gemäß einem der Ansprüche 9 oder 10, wobei der Halbleiterschaltkreis (4) mit einer ersten Vergussmasse (6) und einer zweiten Vergussmasse (601) ummantelt ist und wobei die erste Vergussmasse (6) aus einem von der zweiten Vergussmasse (601) verschiedenes Material ist.

12. Verwendung eines Datenträgers gemäß einem der Ansprüche 9 bis 11 als ein Teilnehmeridentifikationsmodul für den bestimmungsgemäßen Einsatz in einem Endgerät.

## Claims

1. A method for manufacturing a portable data carrier, in particular a chip card, having the method steps of:
- making available a carrier band (1) having an upper side (101) and a lower side (102) disposed opposite the upper side (101), wherein on the upper side (101) a contact field (2) is formed having at least one contact area (200);
- arranging a semiconductor circuit (4) on the lower side (102) of the carrier band (1), wherein the semiconductor circuit (4) is electroconductively connected to the corresponding contact area (200); and
- executing an injection molding process in such a fashion that on the lower side (102) a potting compound (6) is formed around the semiconductor circuit (4), wherein said potting compound (6) has the outer dimensions in accordance with a standard specification of a portable data carrier, **characterized in that**:
- an injection channel (7) for injecting the potting compound (6) is arranged on a side of a data carrier body (3) that is parallel to the lower side (102) of the carrier band (1), such that a depression (702) is created in the location of the injection channel (7),
wherein the data carrier is a subscriber identification module for proper use in a terminal, and the depression (702) is provided to make the handling of the subscriber identification module easier for a user of the subscriber identification module upon incorporation in the terminal and/or upon removal from the terminal.

2. The method according to any of the preceding claims, wherein the injection channel (7) for injecting the potting compound (6) is arranged on the side of the potting compound mold (600) that is parallel to the lower side (102), thereby producing the depression (702).

3. The method according to any of the preceding claims, wherein the depression (702) is arranged in the center of the data carrier and uneven areas (703) are contained in an inner region of the depression.

4. The method according to any of the preceding claims, wherein the potting compound (6) is a first potting compound (6) and the semiconductor circuit (4) was already encased with a second potting compound (601) before the injection molding process.

5. The method according to any of the preceding claims, wherein the carrier band (1) is pre-punched in such a fashion that upon singling the data carriers less carrier band material is severed.

6. The method according to any of the preceding claims, wherein the data carrier is electrically personalized in a personalization unit before a singling step, thereby individualizing the data carrier.

7. The method according to any of the preceding claims, wherein the data carrier is optically personalized before a singling step.

8. The method according to any of the preceding claims, wherein the data carrier is singled by separating the portion of the carrier band (1) that is connected to the potting compound from the rest of the carrier band.

9. A portable data carrier, in particular a chip card, for contact-type data exchange with a terminal, having:
- a carrier band (1) having an upper side (101) and a lower side (102) disposed opposite the upper side (102), wherein on the upper side (101) a contact field (2) is formed having at least one contact area (200);
- a semiconductor circuit (4) on the lower side (102), wherein the semiconductor circuit (4) is electroconductive with the at least one contact area (200);
- a data carrier body (3) of a potting compound material, wherein the potting compound (6) surrounds the semiconductor circuit (4) and the potting compound (6) has the outer dimensions according to a standard specification of a portable data carrier;
**characterized in that**:
- the finished data carrier body (3) has a depression (702) on a side of the data carrier body (3) that is parallel to the lower side (102) of the carrier band (1).

10. The portable data carrier according to claim 9, wherein the depression (702) has uneven areas (703) in an inner region, wherein, despite the uneven areas (703), the data carrier body (3) does not exceed the maximum height (h) of the data carrier body (3) described according to the standard specification.

11. The portable data carrier according to any of the claims 9 or 10, wherein the semiconductor circuit (4) is encased with a first potting compound (6) and a second potting compound (601), and wherein the first potting compound (6) is of a material that differs from the second potting compound (601).

12. The utilization of a data carrier according to any of the claims 9 to 11 as a subscriber identification module for proper use in a terminal.

## Revendications

1. Procédé de fabrication d'un support de données portable, en particulier d'une carte à puce, comportant les étapes :
- mise à disposition d'une bande support (1) ayant une face de dessus (101) et une face de dessous (102) opposée à la face de dessus (101), cependant que, sur la face de dessus (101), un champ de contact (2) ayant au moins une surface de contact (200) est réalisé;
- agencement d'un circuit à semi-conducteur (4) sur la face de dessous (102) de la bande support (1), le circuit à semi-conducteur (4) étant connecté de manière électroconductrice à la surface de contact (200) correspondante; et
- exécution d'un processus de moulage par injection de telle façon que, sur la face de dessous (102), autour du circuit à semi-conducteur (4), une masse de scellement (6) est réalisée, cette masse de scellement (6) présentant les dimensions extérieures correspondant à une spécification standard d'un support de données portable
**caractérisé en ce que**:
- un canal d'injection (7) destiné à l'injection de la masse de scellement (6) est agencé sur une face d'un corps de support de données (3) parallèle à la face de dessous (102) de la bande support (1), de telle sorte que, à l'endroit du canal d'injection (7), un renfoncement (702) est engendré,
le support de données étant un module d'identification d'abonné pour l'utilisation conforme à sa destination dans un terminal, et le renfoncement (702) étant prévu pour faciliter à un utilisateur du module d'identification d'abonné le maniement du module d'identification d'abonné lors de l'insertion dans le terminal et/ou lors du retirement du terminal.

2. Procédé selon une des revendications précédentes, le canal d'injection (7) étant, pour l'injection de la masse de scellement (6), agencé sur la face du moule à masse de scellement (600) parallèle à la face de dessous (102), ce qui a pour effet d'engendrer le renfoncement (702).

3. Procédé selon une des revendications précédentes, le renfoncement (702) étant agencé au centre du support de données et en ce que, dans une zone interne du renfoncement, il y a des aspérités (703).

4. Procédé selon une des revendications précédentes, la masse de scellement (6) étant une première masse de scellement (6) et le circuit à semi-conducteur (4) ayant déjà été enrobé d'une deuxième masse de scellement (601) avant le processus de moulage par injection.

5. Procédé selon une des revendications précédentes, la bande support (1) étant prédécoupée de telle façon que, lors de l'isolation des supports de données, moins de matériau de bande support est sectionné.

6. Procédé selon une des revendications précédentes, le support de données étant, avant une étape de l'isolation, personnalisé électriquement dans une unité de personnalisation, ce qui donne lieu à une individualisation du support de données.

7. Procédé selon une des revendications précédentes, le support de données étant, avant une étape de l'isolation, personnalisé optiquement.

8. Procédé selon une des revendications précédentes, le support de données portable étant séparé, ce qui est obtenu par le fait que la partie de la bande support (1) reliée à la masse de scellement est séparée du reste de la bande support.

9. Support de données portable, en particulier carte à puce, pour l'échange de données à contact avec un terminal, comportant :
- une bande support (1) ayant une face de dessus (101) et une face de dessous (102) opposée à la face de dessus (102), cependant que, sur la face de dessus (101), un champ de contact (2) ayant au moins une surface de contact (200) est réalisé;
- un circuit à semi-conducteur (4) sur la face de dessous (102), le circuit à semi-conducteur (4) étant en conduction électrique avec la au moins une surface de contact (200);
- un corps de support de données (3) en un matériau de masse de scellement, la masse de scellement (6) entourant le circuit à semi-conducteur (4) et la masse de scellement (6) ayant les dimensions extérieures correspondant à une spécification standard d'un support de données portable; **caractérisé en ce que**:
- le corps de support de données (3) achevé comporte sur une face du corps de support de données (3) parallèle à la face de dessous (102) de la bande support (1) un renfoncement (702).

10. Support de données portable conforme à la revendication 9, le renfoncement (702) comportant dans une zone interne des aspérités (703), le corps de support de données (3) ne dépassant pas, malgré les aspérités (703), la hauteur maximale (h) du corps de support de données (3) décrite suivant la spécification standard.

11. Support de données portable à une des revendications 9 ou 10, le circuit à semi-conducteur (4) étant enrobé d'une première masse de scellement (6) et d'une deuxième masse de scellement (601), et la première masse de scellement (6) consistant en un matériau différent de la deuxième masse de scellement (601).

12. Emploi d'un support de données conformément à une des revendications de 9 à 11 en tant que module d'identification d'abonné pour l'utilisation conforme à sa destination dans un terminal.
